# EUROPEAN PATENT APPLICATION

(11) **EP 1 313 224 A2**
(43) Date of publication of application: **21.05.2003**
(21) Application number: 02257923.9
(22) Date of filing: 15.11.2002
(51) Int. Cl.: H03L 7/091, H03L 7/20

(54) **Analog phase locked oscillator**

(30) Priority: 16.11.2001 JP 2001351560
(71) Applicant: ALPS ELECTRIC CO., LTD., Ota-ku Tokyo 145 (JP)
(72) Inventor: Suzuki, Shigetaka, Otsuka-cho, Ota-ku, Tokyo (JP); Takayama, Akira, Otsuka-cho, Ota-ku, Tokyo (JP)
(74) Representative: Kensett, John Hinton

(57) **Abstract**

There is provided a voltage-controlled oscillator (5) whose oscillation frequency is controlled by a control voltage, a reference oscillator (1), and a sampling phase detector (3) for receiving an oscillation signal of the voltage-controlled oscillator and a reference oscillation signal of the reference oscillator and for inputting, to the voltage-controlled oscillator, as the control voltage, an error voltage that is obtained on the basis of a phase difference between the oscillation signal and a harmonic of the reference oscillation signal. An irreversible circuit element (6) is provided between the voltage-controlled oscillator and the sampling phase detector. The oscillation signal that is output from the voltage-controlled oscillator is input to the sampling phase detector via the irreversible circuit element.

## Description

### BACKGROUND OF THE INVENTION

### 1. Field of the Invention

The present invention relates to an analog phase-locked oscillator suitable for generation of an oscillation signal in a microwave band.

### 2. Description of the Related Art

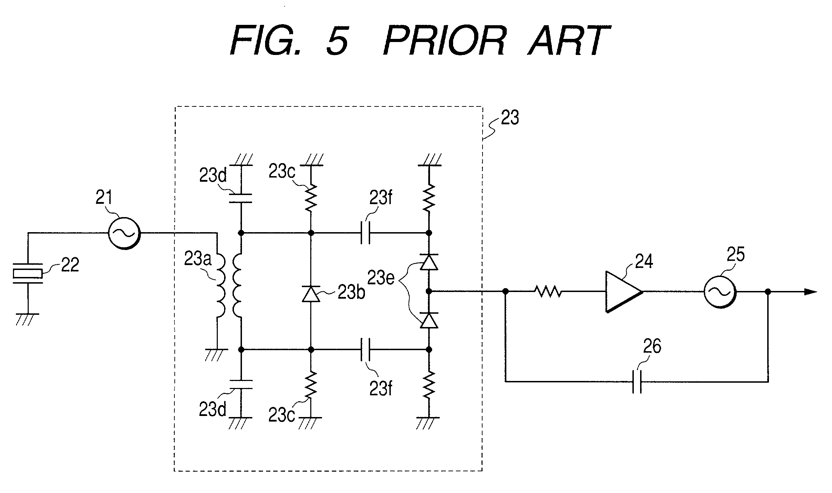

A conventional analog phase-locked oscillator will be described below with reference to Fig. 5. Having a quartz resonator 22, a reference oscillator 21 supplies a reference oscillation signal of 120 MHz, for example, to the unbalance side of a balance-unbalance conversion transformer 23a of a sampling phase detector 23. A step-recovery diode 23b is coupled in parallel to the balance side of the balance-unbalance conversion transformer 23a. The two ends of the step-recovery diode 23b are grounded via resistors 23c and capacitors 23d. A mixer diode pair 23e, which is a series connection of two diodes that have the same characteristics and are arranged in the same direction (pn junction direction), is connected in parallel to the step-recovery diode 23b via capacitors 23f. The two ends of the mixer diode pair 23e are grounded via respective resistors 23g.

The connecting point of the two diodes of the mixer diode pair 23e is connected to the input terminal of a loop amplifier 24, whose output terminal is connected to the control terminal of a voltage-controlled oscillator 25. The output terminal of the voltage-controlled oscillator 25 is coupled to the connecting point of the two diodes of the mixer diode pair 23e via a coupling capacitor 26.

The voltage-controlled oscillator 25 is so constructed as to oscillate at, for example, 75 times the frequency of the reference oscillation signal, that is, 9 GHz, when a prescribed control voltage is applied to the control terminal. The loop amplifier 24 is so set as to output the above prescribed control voltage when the voltage at the connecting point of the two diodes of the mixer diode pair 23e is equal to 0 V.

With the above configuration, the step-recovery diode 23b generates harmonics of the reference oscillation signal, which are input to the mixer diode pair 23e via the capacitors 23f. The oscillation signal that is output from the voltage-controlled oscillator 25 is also input to the mixer diode pair 23e via the coupling capacitor 26. In the mixer diode pair 23e, the voltage at the connecting point of the two diodes of the mixer diode pair 23e becomes 0 V when a 75th harmonic and an oscillation signal of 9 GHz have a prescribed phase relationship (their frequencies become identical). As a result, the prescribed control voltage is supplied to the voltage-controlled oscillator 25 and the voltage-controlled oscillator 25 starts to oscillate at a constant frequency of 9 GHz. Even if the oscillation frequency of the voltage-controlled oscillator 25 has varied for a certain reason, the voltage at the connecting point of the two diodes of the mixer diode pair 23e varies in the positive or negative direction to change the control voltage. As a result, the oscillation frequency of the voltage-controlled oscillator 25 is kept at 9 GHz.

The above-described analog phase-locked oscillator is used as a local oscillation signal source for microwave communication devices. However, because of the generation of harmonics of the reference oscillation signal, many harmonics other than the particular harmonic to be used go through the mixer diode pair 23e and the coupling capacitor 26 and appear at the output side of the voltage-controlled oscillator 25. This results in a problem that such spurious harmonics enter other circuits as interference signals. This problem is particularly serious in the case of using a high-order harmonic.

### SUMMARY OF THE INVENTION

An object of the present invention is to provide an analog phase-locked oscillator that removes harmonics generated by the step-recovery diode other than a particular harmonic to be used and thereby prevents those harmonics from leaking to the output side of the voltage-controlled oscillator.

To attain the above object, the invention provides an analog phase-locked oscillator comprising a voltage-controlled oscillator an oscillation frequency of which is controlled by a control voltage; a reference oscillator; a sampling phase detector for receiving an oscillation signal of the voltage-controlled oscillator and a reference oscillation signal of the reference oscillator and for inputting, to the voltage-controlled oscillator, as the control voltage, an error voltage that is obtained on the basis of a phase difference between the oscillation signal and a harmonic of the reference oscillation signal; and an irreversible circuit element provided between the voltage-controlled oscillator and the sampling phase detector, wherein the oscillation signal is input to the sampling phase detector via the irreversible circuit element. This configuration prevents harmonics from leaking to the output side of the voltage-controlled oscillator and impairing operation of other circuits that are provided on the output side of the voltage-controlled oscillator.

The irreversible circuit element may be an isolator. This makes it possible to easily prevent leakage of harmonics.

The irreversible circuit element may also be a wide-band amplifier. This makes it possible to prevent leakage of harmonics in a wider band.

The sampling phase detector may comprise a step-recovery diode for generating the harmonic and a series-connection mixer diode pair for mixing the harmonic and the oscillation signal together and for comparing phases thereof, wherein two ends of the step-recovery diode are coupled to two ends of the mixer diode pair via resonance circuits that resonate with a particular harmonic of the reference oscillation signal, respectively, so as to allow only the particular harmonic easily reach the mixer diode pair. This arrangement, together with the irreversible circuit element, makes it even more difficult for harmonics other than the particular harmonic to leak to the output side of the voltage-controlled oscillator.

The analog phase-locked oscillator may be such that the resonance circuits are series resonance circuits, and that the two ends of the step-recovery diode are connected to the two ends of the mixer diode pair via the series resonance circuits, respectively. This is an easy measure for allowing only the particular harmonic to easily reach the mixer diode pair.

The analog phase-locked oscillator may be such that each of the resonance circuits is a series resonance circuit consisting of a capacitance element and an inductance element, that the two ends of the step-recovery diode are connected to the two ends of the mixer diode pair via the capacitance elements , respectively, and that the two ends of the mixer diode pair are grounded by the respective inductance elements. In this configuration, large voltages develop across the inductance elements for the particular harmonic. That is, voltages that are Q times greater than a voltage generated by the step-recovery diode appear in the series resonance circuits. Therefore, the detection efficiency of the sampling phase detector can be kept high even if the output power of the reference oscillator is lowered.

An embodiment of the present invention will now be described, by way of example only, with reference to the accompanying diagrammatic drawings, in which:
Fig. 1 shows the configuration of an analog phase-locked oscillator according to the present invention;
Fig. 2 is a graph showing a transmission characteristic of an irreversible circuit element that is used in the analog phase-locked oscillator of Fig. 1;
Fig. 3 shows the configuration of another analog phase-locked oscillator according to the invention;
Fig. 4 is a graph showing a transmission characteristic of an irreversible circuit element that is used in the analog phase-locked oscillator of Fig. 3; and
Fig. 5 shows the configuration of a conventional analog phase-locked oscillator.

### DESCRIPTION OF THE PREFERRED EMBODIMENTS

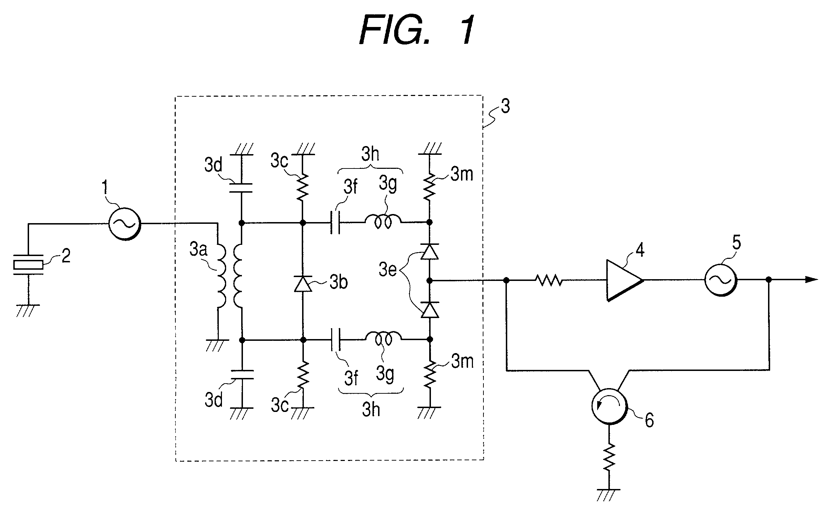

Analog phase-locked oscillators according to the present invention will be hereinafter described with reference to Figs. 1 to 4.

First, a phase-locked oscillator shown in Fig. 1 will be described. Having a quartz resonator 2, a reference oscillator 1 oscillates at 120 MHz, for example. The reference oscillation signal is supplied to the unbalance-side winding of a balance-unbalance conversion transformer 3a of a sampling phase detector 3. A step-recovery diode 3b is connected in parallel to the balance-side winding of the balance-unbalance conversion transformer 3a. The two ends of the step-recovery diode 3b are grounded via resistors 3c and capacitors 3d. With this arrangement, the step-recovery diode 3b generates harmonics of the reference oscillation signal. A mixer diode pair 3e, which is a series connection of two diodes that have the same characteristics and are arranged in the same direction (pn junction direction), is connected in parallel to the step-recovery diode 3b.

One end of the step-recovery diode 3b is connected to one end of the mixer diode pair 3e via a series resonance circuit 3h consisting of a capacitance element 3f and an inductance element 3g. Similarly, the other end of the step-recovery diode 3b is connected to the other end of the mixer diode pair 3e via another series resonance circuit 3h consisting of a capacitance element 3f and an inductance element 3g. The series resonance circuits 3h resonate with a particular harmonic, for example, a 75th harmonic (9 GHz), among the harmonics generated by the step-recovery diode 3b. The two ends of the mixer diode pair 3e are grounded via respective resistors 3m.

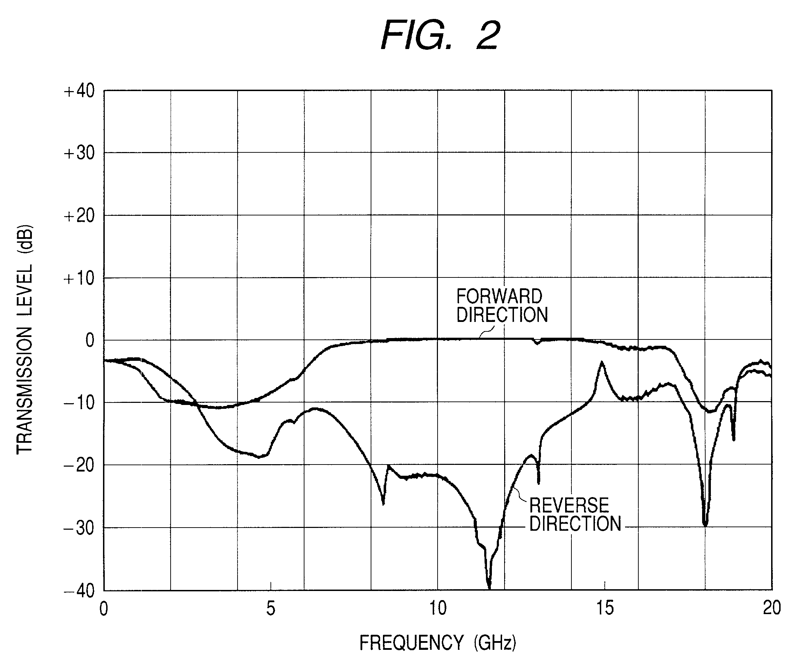

The connecting point of the two diodes of the mixer diode pair 3e is connected to the input terminal of a loop amplifier 4, whose output terminal is connected to the control terminal of a voltage-controlled oscillator 5. The output terminal of the voltage-controlled oscillator 5 is coupled to the connecting point of the two diodes of the mixer diode pair 3e via an irreversible circuit element 6 that is an isolator. Fig. 2 shows forward and reverse transmission characteristics of the isolator. It is seen that good isolation (in terms of the forward-to-reverse transmission ratio) is obtained from about 6 GHz to about 15 GHz.

The voltage-controlled oscillator 5 is so constructed as to oscillate at, for example, 75 times the frequency of the reference oscillation signal, that is, 9 GHz, when a prescribed control voltage is applied to the control terminal. The loop amplifier 4 is so set as to output the above prescribed control voltage when the voltage at the connecting point of the two diodes of the mixer diode pair 3e is equal to 0 V.

With the above configuration, harmonics generated by the step-recovery diode 3b are input to the mixer diode pair 3e. Because of the presence of the series resonance circuits 3h, the 75th harmonic has a highest level when input to the mixer diode pair 3e and the other harmonics are attenuated. The oscillation signal that is output from the voltage-controlled oscillator 5 is also input to the mixer diode pair 3e. In the mixer diode pair 3e, the voltage at the connecting point of the two diodes of the mixer diode pair 3e becomes 0 V when a harmonic and the oscillation signal have a prescribed phase relationship (their frequencies become identical). As a result, the prescribed control voltage is supplied to the voltage-controlled oscillator 5 and the voltage-controlled oscillator 5 starts to oscillate at 9 GHz. Even if the oscillation frequency of the voltage-controlled oscillator 5 has varied, the voltage at the connecting point of the two diodes of the mixer diode pair 3e varies in the positive or negative direction and a control is so made that the oscillation frequency of the voltage-controlled oscillator 5 is kept at 9 GHz.

In the above configuration, the series resonance circuits 3h are employed so that the particular harmonic (75th harmonic) is input to the mixer diode pair 3e. The other harmonics are attenuated according to the resonance characteristic of the series resonance circuits 3h. Therefore, harmonics close to the 75th harmonic pass through the mixer diode pair 3e without being attenuated much. However, since the isolator (irreversible circuit element) 6 is provided, the harmonics close to the 75th harmonic hardly leak to the output side of the voltage-controlled oscillator 5.

As described above, by virtue of the resonance circuits 3e and the isolator 6, the harmonics of the reference oscillation signal other than the particular harmonic that cover a wide range hardly leak to the output side of the voltage-controlled oscillator 5.

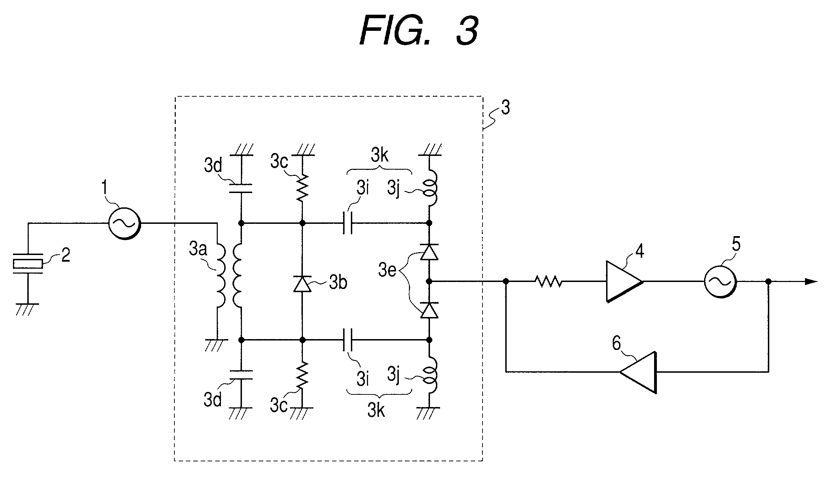

Fig. 3 shows another analog phase-locked oscillator in which a wide-band amplifier is used as an irreversible circuit element 6. One end of the step-recovery diode 3b is connected to one end of the mixer diode pair 3e via a capacitance element 3i of a series resonance circuit 3k, and the other end of the step-recovery diode 3b is connected to the other end of the mixer diode pair 3e via a capacitance element 3i of another series resonance circuit 3k. The two ends of the mixer diode pair 3e are grounded via inductance elements 3j of the series resonance circuits 3k. The other part of the configuration of this analog phase-locked oscillator is the same as shown in Fig. 1.

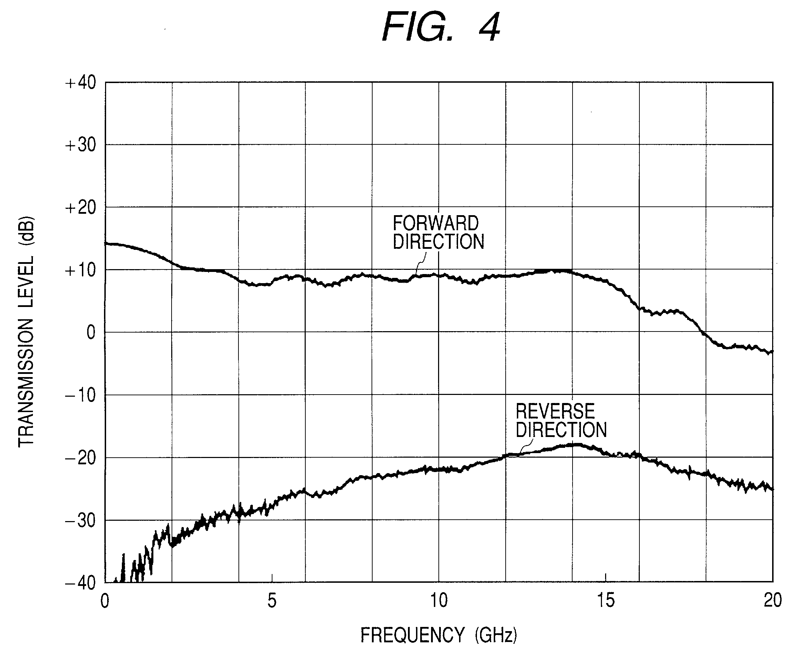

Fig. 4 shows a transmission characteristic of the wide-band amplifier 6. Since good isolation is obtained up to 20 GHz or more, the degrees of leakage of harmonics other than a particular harmonic to the output side of the voltage-controlled oscillator 5 can be reduced in a wider range.

With this configuration, a 75th harmonic that is generated by the step-recovery diode 3b resonates with the series resonance circuits 3k and large voltages develop across the inductance elements 3j. That is, voltages that are Q times greater than the voltage generated by the step-recovery diode 3b appear in the series resonance circuits 3k. Therefore, the detection efficiency of the sampling phase detector 3 can be kept high even if the output power of the reference oscillator 1 is lowered.

No problems occur even if the series resonance circuits 3k of Fig. 3 are replaced by the series resonance circuits 3h of Fig. 1.

## Claims

1. An analog phase-locked oscillator comprising:
a voltage-controlled oscillator an oscillation frequency of which is controlled by a control voltage;
a reference oscillator;
a sampling phase detector for receiving an oscillation signal of the voltage-controlled oscillator and a reference oscillation signal of the reference oscillator and for inputting, to the voltage-controlled oscillator, as the control voltage, an error voltage that is obtained on the basis of a phase difference between the oscillation signal and a harmonic of the reference oscillation signal; and
an irreversible circuit element provided between the voltage-controlled oscillator and the sampling phase detector,
wherein the oscillation signal is input to the sampling phase detector via the irreversible circuit element.

2. The analog phase-locked oscillator according to claim 1, wherein the irreversible circuit element is an isolator.

3. The analog phase-locked oscillator according to claim 1, wherein the irreversible circuit element is a wide-band amplifier.

4. The analog phase-locked oscillator according to claim 2, wherein the sampling phase detector comprises a step-recovery diode for generating the harmonic and a series-connection mixer diode pair for mixing the harmonic and the oscillation signal together and for comparing phases thereof, and wherein two ends of the step-recovery diode are coupled to two ends of the mixer diode pair via resonance circuits that resonate with a particular harmonic of the reference oscillation signal, respectively, so as to allow only the particular harmonic to easily reach the mixer diode pair.

5. The analog phase-locked oscillator according to claim 4, wherein the resonance circuits are series resonance circuits, and wherein the two ends of the step-recovery diode are connected to the two ends of the mixer diode pair via the series resonance circuits, respectively.

6. The analog phase-locked oscillator according to claim 4, wherein each of the resonance circuits is a series resonance circuit consisting of a capacitance element and an inductance element, wherein the two ends of the step-recovery diode are connected to the two ends of the mixer diode pair via the capacitance elements, respectively, and wherein the two ends of the mixer diode pair are grounded by the respective inductance elements.

7. The analog phase-locked oscillator according to claim 3, wherein the sampling phase detector comprises a step-recovery diode for generating the harmonic and a series-connection mixer diode pair for mixing the harmonic and the oscillation signal together and for comparing phases thereof, and wherein two ends of the step-recovery diode are coupled to two ends of the mixer diode pair via resonance circuits that resonate with a particular harmonic of the reference oscillation signal, respectively, so as to allow only the particular harmonic to easily reach the mixer diode pair.

8. The analog phase-locked oscillator according to claim 7, wherein the resonance circuits are series resonance circuits, and wherein the two ends of the step-recovery diode are connected to the two ends of the mixer diode pair via the series resonance circuits, respectively.

9. The analog phase-locked oscillator according to claim 7, wherein each of the resonance circuits is a series resonance circuit consisting of a capacitance element and an inductance element, wherein the two ends of the step-recovery diode are connected to the two ends of the mixer diode pair via the capacitance elements, respectively, and wherein the two ends of the mixer diode pair are grounded by the respective inductance elements.
